# EUROPEAN PATENT APPLICATION

(11) **EP 4 610 407 A1**
(43) Date of publication of application: **03.09.2025**
(21) Application number: 23900913.7
(22) Date of filing: 06.11.2023
(51) Int. Cl.: C25D 1/04, C25D 1/22, C25D 5/12, C25D 3/56, B32B 15/08, H05K 3/02

(54) **COPPER FOIL ATTACHED TO CARRIER FOIL AND COPPER CLAD LAMINATE USING SAME**

(30) Priority: 08.12.2022 KR 20220170337
(71) Applicant: LOTTE ENERGY MATERIALS CORPORATION, Iksan-si, Jeollabuk-do 54586 (KR)
(72) Inventor: YANG, Chang Yol, Iksan-si Jeollabuk-do 54586 (KR); KIM, Geul Han, Iksan-si Jeollabuk-do 54586 (KR); BEOM, Won Jin, Iksan-si Jeollabuk-do 54586 (KR); KIM, Hyung Cheol, Iksan-si Jeollabuk-do 54586 (KR); SONG, Kideok, Iksan-si Jeollabuk-do 54586 (KR)
(74) Representative: Mammel und Maser Patentanwälte PartG mbB
(86) International application number: PCT/KR2023/017613
(87) International publication number: WO 2024/122893

(57) **Abstract**

The present invention relates to a copper foil attached to a carrier foil having good peel strength under high-temperature pressing conditions. The present invention provides an ultra-thin copper foil attached to a carrier foil, comprising: a carrier foil; a peeling layer on the carrier foil; a heat-resistant layer on the peeling layer; and an ultra-thin foil on the heat-resistant layer, wherein the copper foil attached to the carrier foil has a buffer layer, formed of a Ni alloy, interposed between the peeling layer and the heat-resistant layer.

## Description

### [Technical Field]

The present disclosure relates to a carrier foil-attached copper foil and a copper-clad laminate manufactured using the same and, specifically, to a carrier foil-attached copper foil having favorable peel strength under high-temperature pressing conditions and a copper-clad laminate using the same.

### [Background Art]

Conventional carrier foil-attached copper foils for semiconductor devices typically have a lamination structure with a release layer, a diffusion barrier layer, and an ultra-thin copper foil formed above a carrier foil.

Conventionally, a press process was performed at 220-240°C in order to join carrier foil-attached copper foils to resin substrates, but recently, carrier foil-attached copper foils have been subjected to press molding at high temperatures of 350°C or higher due to the use of highly heat-resistant resin substrates. In such a case, crater-type copper foil blistering occurs between carrier foils and ultra-thin copper foils, or diffusion barrier layers cannot withstand high-temperature processes to cause an increase in peel strength between the carrier foils and the ultra-thin copper foils.

### [Disclosure]

### [Technical Problem]

The present inventors found that an insufficient or excessive amount of nickel in a diffusion barrier layer during press molding at a high temperature of 350°C or higher reduced the stability of the release strength between a carrier foil and an ultra-thin foil or caused crater-type copper foil blistering. Accordingly, an aspect of the present disclosure is to provide a carrier foil-attached copper foil having a lamination structure whereby copper foil blistering is suppressed at the time of high-temperature press molding.

Meanwhile, the present inventors found that when a carrier foil-attached copper foil having the above-described lamination structure is used to suppress copper foil blistering, a peel strength of 10 gf/cm or less may cause defects since the carrier foil and the copper foil may be easily separated during the manufacturing of a copper-clad laminate and a peel strength of 30 gf/cm or more may cause substrate warping defects such as the carrier foil is difficult to separate during the manufacturing of a copper-clad laminate.

Accordingly, an aspect of the present disclosure is to provide a copper foil lamination structure in a carrier foil-attached copper foil wherein the peel strength between the carrier foil and the ultra-thin foil is maintained at 10-30 gf/cm.

Another aspect of the present disclosure is to provide a copper-clad laminate manufactured using the above-described carrier foil-attached copper foil.

### [Technical Solution]

In accordance with an aspect of the present disclosure, there is provided a carrier foil-attached copper foil including: a carrier foil; a release layer on the carrier foil; a heat-resistant layer on the release layer; and an ultra-thin copper foil on the heat-resistant layer, wherein a buffer layer of a Ni alloy is interposed between the release layer and the heat-resistant layer.

The buffer layer may contain a Cu-Ni alloy. The buffer layer may be obtained by plating with a plating solution with a concentration ratio of Cu and Ni being 1:5 to 1:20.

The buffer layer may have a thickness of 20-50 nm.

The heat-resistant layer may have a thickness of 5-50 nm.

The release layer may be an organic release layer or an inorganic release layer.

The heat-resistant layer may be a Ni plating layer or the heat-resistant layer nay be obtained by plating with a plating solution containing Ni and P.

In the carrier foil-attached copper foil, the 90-degree peel strength after press processing at 400°C for 60 min may be 10-30 gf/cm.

In accordance with another aspect of the present disclosure, there is provided a copper-clad laminate including a copper foil laminated on a resin substrate, wherein the copper foil is prepared by joining the carrier foil-attached copper foil to the resin substrate.

The resin substrate may be at least one selected from the group consisting of a polyimide, a fluorine resin, and an LCP resin.

### [Advantageous Effects]

According to the present disclosure, a carrier foil-attached copper foil can be provided having a lamination structure whereby copper foil blistering is suppressed at the time of press molding at a temperature as high as 350°C or higher.

Furthermore, according to the present disclosure, the peel strength between the carrier foil and the ultra-thin foil can be maintained at 10-30 gf/cm even when a carrier foil-attached copper foil having a lamination structure for suppressing copper foil blistering is used.

### [Description of Drawings]

The accompanying drawings, which are included as a part of the description to help the understanding of the disclosure, provide embodiments of the disclosure and, together with the description, explain the technical spirit of the disclosure.
FIG. 1 illustrates a carrier foil-attached copper foil 100, according to an embodiment of the present disclosure.
FIGS. 2A and 2B are optical microscope images taken from released surfaces after samples of an example and a comparative example were subjected to press processing at 350°C and then releasing, respectively.
FIGS. 3A and 3B are AES analysis graphs of carrier foil-attached copper foil samples manufactured in an example and a comparative example, respectively.
FIG. 4 is a graph showing peel strength measurement results after samples of an example and a comparative example were subjected to pressing at 400°C.
FIG. 5 shows a press condition profile at the time of peel strength measurement.

### [Best Mode]

Throughout the respective drawings, the same reference numerals are used for the same elements if possible. The detailed descriptions of already known functions and/or configurations are omitted. The following description focuses on parts necessary for understanding the operation according to various embodiments, and descriptions of elements that may obscure the subject matter of the description are omitted. In addition, some elements of the drawings may be exaggerated, omitted, or schematically illustrated. The size of each element does not entirely reflect the actual size, and thus the contents described herein are not limited by the relative size or spacing of the elements drawn in the respective drawings.

While describing the present disclosure, when it is determined that a detailed description of a known art related to the present disclosure may unnecessarily obscure the subject matter of the present disclosure, the detailed description will be omitted. The terminology used in the detailed description of the present disclosure is provided only to describe embodiments of the present disclosure and not for purposes of limitation. Unless the context clearly indicates otherwise, the singular forms include the plural forms. It should be understood that the terms "comprise", "include", "contain", or the like specify some features, numbers, steps, operations, elements, or some or combinations thereof when used herein, but do not preclude the presence or possibility of one or more other features, numbers, steps, operations, elements, or some or combinations thereof in addition to the description.

The terms first, second, and the like may be used herein to describe various elements. These elements should not be limited by these terms, as these terms are only used to distinguish one element from another.

As used herein, the term "lamination" refers to bonding of at least two layers. For example, the lamination of a first layer and a second layer includes not only a direct contact of the first and second layers but also the bonding of the first and second layers with an additional third layer interposed therebetween.

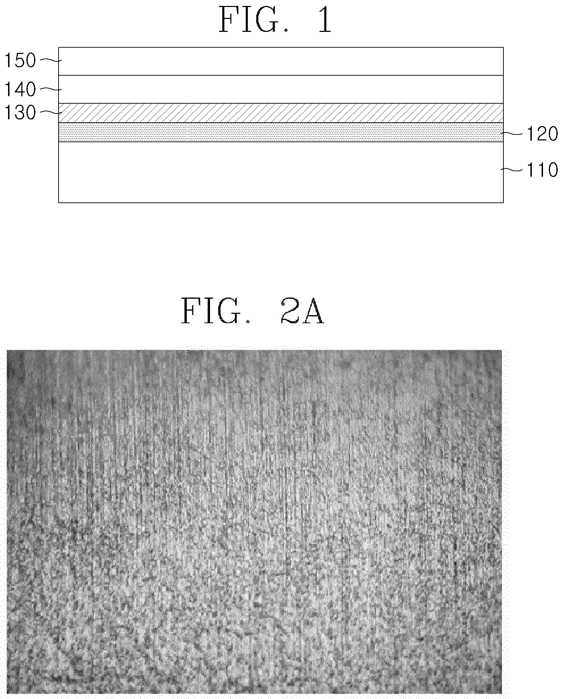

FIG. 1 illustrates a carrier foil-attached ultra-thin copper foil 100 according to an embodiment of the present disclosure.

Referring to FIG. 1, the carrier foil-attached copper foil according to an embodiment of the present disclosure may have a structure in which a carrier foil 110, a release layer 120, a buffer layer 130, a heat-resistant layer 140, and an ultra-thin copper foil 150 are laminated.

The carrier foil 110 serves as a support (carrier) until the ultra-thin copper foil is joined to an insulating substrate. The carrier foil may employ an aluminum foil, a stainless steel foil, a titanium foil, a copper foil, or a copper alloy foil. For example, an electrolytic copper foil, an electrolytic copper alloy foil, a rolled copper foil, or a rolled copper alloy foil may be employed. Preferably, the carrier foil may be an electrolytic copper foil, and an upper surface 100B of the carrier foil may be any one of a glossy surface or a matte surface. A lower surface 100A of the carrier foil may have a roughened layer.

The carrier foil may have a thickness of 1 mm or less. For example, the thickness of the carrier foil may be 10 to 100 µm. For example, the thickness of the carrier foil may be 12 to 18 µm. The carrier foil, when having a thickness of less than 10 µm, may be difficult to serve as a carrier, and the carrier foil, when having a thickness of more than 1 mm, may not have a problem in serving as a carrier but, in a case of continuous plating for forming the release layer, the ultra-thin copper foil, or the like, the tension of the foil needs to be increased in a continuous plating line and a large-scale facility is needed.

The roughness (R_{z}) of the carrier foil may be 1.7 µm or less, 1.5 µm or less, or 1.3 µm or less. In addition, the roughness (R_{z}) of the carrier foil may be 0.7 µm or more, 0.9 µm or more, or 1.1 µm or more.

In the carrier foil-attached copper foil, the release layer 120 is a layer for improving release properties when the ultra-thin copper foil and the carrier foil are released from each other, and the release layer is introduced to release the carrier foil clearly and easily. The release layer is removed integrally with the carrier foil.

The release layer 130 may contain a metal or metal alloy having release properties. The releasable metal may include molybdenum or tungsten. The release layer 130 may contain a plating catalyst. For example, the release layer 130 may contain at least one metal selected from the group consisting of Fe, Co, and Ni.

The release layer may be an organic release layer having release properties. For example, the release layer may contain at least one organic material selected from the group consisting of benzotriazol (BTA)-based organic materials.

The heat-resistant layer 140 may contain at least one element selected from the group consisting of Ni, Co, Fe, Cr, Mo, W, Al, and P. For example, the heat-resistant layer may be a single metal layer, an alloy layer of two or more metals, or at least one metal oxide layer.

For example, plating for forming a binary alloy layer may include nickel plating, cobalt plating, iron plating, aluminum plating, and the like. Plating for forming a binary alloy layer may include nickel-cobalt plating, nickel-iron plating, nickel-chromium plating, nickel-molybdenum plating, nickel-tungsten plating, nickel-copper plating, nickel-phosphorus plating, cobalt-iron plating, cobalt-chromium plating, cobalt-molybdenum plating, cobalt-tungsten plating, cobalt-copper plating, cobalt-phosphorus plating, and the like. Plating for forming a ternary alloy layer may include nickel-cobalt-iron plating, nickel-cobalt-chromium plating, nickel-cobalt-molybdenum plating, nickel-cobalt-tungsten plating, nickel-cobalt-copper plating, nickel-cobalt-phosphorus plating, nickel-iron-chromium plating, nickel-Iron-molybdenum plating, nickel-iron-tungsten plating, nickel-iron-copper plating, nickel-iron-phosphorus plating, nickel-chromium-molybdenum plating, nickel-chromium-tungsten plating, nickel-chromium-copper plating, nickel-chromium-phosphorus plating, nickel-molybdenum-tungsten plating, nickel-molybdenum-copper plating, nickel-molybdenum-phosphorus plating, nickel-tungsten-copper plating, nickel-tungsten-phosphorus plating, nickel-copper-phosphorus plating, cobalt-iron-chromium plating, cobalt-iron-molybdenum plating, cobalt-iron-tungsten plating, cobalt-iron-copper plating, cobalt-iron-phosphorus plating, cobalt-chromium-molybdenum plating, cobalt-chromium-tungsten plating, cobalt-chromium- copper plating, cobalt-chromium-phosphorus plating, cobalt-molybdenum-phosphorus plating, cobalt-tungsten-copper plating, cobalt-molybdenum-phosphorus plating, cobalt-tungsten-copper plating, cobalt-tungsten-phosphorus plating, cobalt-copper-phosphorus plating, and the like.

Preferably, the heat-resistant layer 120 may be a Ni-P plating layer containing Ni and P.

The heat-resistant layer 140 suppresses the diffusion of copper into the release layer when the carrier foil-attached copper foil is pressed with an insulating substrate at a high temperature. The diffusion of copper into the release layer may form metal bonds between the carrier foil and the ultra-thin copper foil, and thus the strong bonding strength therebetween may hinder the releasing of the carrier foil, and the heat-resistant layer 140 can suppress this reaction.

The amount of metal deposition in the heat-resistant layer 140 may be 50 µg/dm² or more, 60 µg/dm² or more, or 70 µg/dm² or more, and the amount of metal deposition may be 120 µg/dm² or less, 110 µg/dm² or less, or 100 µg/dm² or less. The amount of metal deposition in the heat-resistant layer may be the amount of Ni deposition.

In the heat-resistant layer 140, a low amount of nickel increases the peel strength between the carrier foil and the ultra-thin foil and a high amount of nickel causes crater-type copper foil blistering. In the present disclosure, the above-described problems are solved by further laminating a buffer layer having a Ni content different from that of the heat-resistant layer.

The thickness of the heat-resistant layer 140 may be 5 nm or more, 7 nm or more, or 10 nm or more. The thickness of the heat-resistant layer is preferably 50 nm or less, 30 nm or less, or 20 nm.

The carrier foil-attached copper foil of the present disclosure includes a buffer layer 130 between the release layer 120 and the heat-resistant layer 140. The buffer layer 130 protects the release layer under high-temperature press conditions of 350°C or higher, suppresses the diffusion of copper between the carrier foil and the ultra-thin foil to prevent blistering, and ensures the stability of peel strength.

The thickness of the buffer layer 130 may be 20 nm or more or 30 nm or more. The thickness of the buffer layer 130 may be 60 nm or less or 50 nm or less. For example, the thickness of the buffer layer 130 may be 20-50 nm. A thickness of 20 nm or less of the buffer layer may be ineffective to cause blistering, and a thickness of 50 nm or more of the buffer layer may significantly lower the peel strength to cause swelling between the carrier foil and the ultra-thin foil.

The thickness ratio of the heat-resistant layer and the buffer layer may be 1:1.5 to 1:5. Preferably, the thickness ratio of the heat-resistant layer and the buffer layer may be 1.2 to 1.3.

The buffer layer 130 is preferably a Ni alloy layer. More preferably, the buffer layer 130 may be a Cu-Ni alloy layer.

The amount of Ni deposition in the buffer layer 130 may be 50 µg/dm² or more, 60 µg/dm² or more, 70 µg/dm² or more, 80 µg/dm² or more, 90 µg/dm² or more, or 100 µg/dm² or more. The amount of Ni deposition in the buffer layer 130 is preferably 300 µg/dm² or less, 250 µg/dm² or less, 200 µg/dm² or less, or 150 µg/dm² or less.

The buffer layer 130 is preferably formed by electroplating. The buffer layer of a Ni-Cu alloy may be formed from a plating solution with a high Ni content. For example, the buffer layer may be formed by electroplating from a plating solution with a concentration ratio of Cu and Ni being 1:20 to 1:5, and preferably 1:15 to 1:7.

The thickness of the ultra-thin copper foil 150 may be 12 µm or less. Preferably, the thickness of the ultra-thin copper foil may be 1.5-5 µm. The ultra-thin copper foil preferably has a surface roughness (Rz) of 0.5-1.5 µm.

The ultra-thin copper foil may have a roughened surface and a non-roughened surface depending on the use thereof. The roughened surface may be formed through nodulation treatment, and the non-roughened surface may be formed by adding a brightener and a suppressor during the formation of the copper foil.

The surface of the ultra-thin copper foil may be additionally subjected to surface treatment. For example, the surface may be treated with any one of thermal and chemical resistance treatment, chromate treatment, and silane coupling treatment, or a combination thereof, and the type of surface treatment to be performed may be appropriately selected depending on subsequent processes.

The thermal and chemical resistance treatment may be, for example, performed by forming a thin film on a metal foil through sputtering, electroplating, or electroless plating of any one of nickel, tin, zinc, chromium, molybdenum, and cobalt, or an alloy thereof. Considering costs, electroplating is preferable.

For the chromate treatment, an aqueous solution containing hexavalent to trivalent chromium ions may be used. The chromate treatment may be performed by simple immersion treatment, but preferably cathodic treatment. For example, the cathodic treatment is preferably performed under conditions of 0.1 to 70 g/L sodium dichromate, pH 1 to 13, a bath temperature of 15 to 60°C, a current density of 0.1 to 5 A/dm², and an electrolysis time of 0.1 to 100 sec. The chromate treatment is preferably performed on anti-corrosion treatment, whereby moisture resistance and heat resistance may be further improved.

As a silane coupling agent to be used for the silane coupling treatment, at least one material or a mixture selected from the group consisting of epoxy functional silanes, such as 3-glycidoxypropyl trimethoxysilane and 2-(3, 4-epoxycyclohexyl)ethyltrimethoxysilane, amino functional silanes, olefin functional silanes, acrylic functional silanes, methacryl functional silanes, mercapto functional silanes, and the like may be used. For example, the silane coupling agent is dissolved in a solvent, such as water, to a concentration of 0.1 to 15 g/L, and applied to a metal foil at room temperature to a temperature of 70°C or adsorbed on the metal foil by electrodeposition. After the silane coupling treatment, stable bonds may be formed by heating, ultraviolet irradiation, or the like. The heating may be performed at a temperature of 100 to 200°C for 2 to 60 sec.

Hereinbefore, an example of a structure in which a carrier foil, a release layer, a buffer layer, a heat-resistant layer, and an ultra-thin foil, which constitute the carrier foil-attached copper foil, are laminated in sequential contact with each other has been described, but an additional layer may be added as needed between each layer constituting the laminated structure.

For example, a diffusion barrier layer may be added between the carrier foil and the release layer. The diffusion of coper from the carrier foil to the release layer may generate metal bonds, and thus the strong bonding strength therebetween may hinder the releasing of the carrier foil. Therefore, additionally, a diffusion barrier layer may be additionally disposed to introduce such a reaction.

Meanwhile, the carrier foil-attached copper foil of the present disclosure may be attached to a low-dielectric resin, for example, a polyimide, a fluorine resin, or an LCP resin, leading to a copper-clad laminate, and this copper-clad laminate may be used to manufacture printed wiring boards.

Hereinafter, the present disclosure will be described in detail with reference to examples. However, these examples are shown by way of illustration and should not be construed as limiting the present disclosure in any way.

### [Mode for Invention]

### <Example 1>

A carrier foil-attached copper foil was manufactured by the following method.

### A. Carrier foil

An electrolytic copper foil with a surface roughness of 1.2 µm and a thickness of 18 µm was used.

### B. Release layer

An organic release layer was formed under the following conditions.
- Carboxy benzotriazole concentration: 1-5 g/L, Copper concentration: 5-15 g/L, H₂SO₄ concentration: 150 g/L
- Temperature: 40°C, Dipping time: 25 sec

### C. Buffer layer

A buffer layer was formed on the carrier foil under the following plating bath and plating conditions. The thickness of the formed buffer layer was 35 nm.
- Copper concentration: 5-10 g/L, Nickel concentration: 50-100 g/L, Boric acid concentration: 20-50 g/L
- Temperature: 30°C, Current density: 2.0 A/dm², Plating time: 2.5 sec

### D. Heat-resistant layer

A heat-resistant layer was formed under the following plating bath and plating conditions. The amount of Ni deposition in the formed heat-resistant layer was 90 µg/dm².
- Ni concentration: 15-25 g/L, P concentration: 10-20 g/L
- pH: 4.0, Temperature: 30°C, Current density: 0.5 A/dm², Plating time: 6 sec

### E. Ultra-thin copper foil

An ultra-thin copper foil was formed under the following plating bath and plating conditions. The plating thickness was 2 µm.
- CuSO₄·5H₂O: 250 g/L, H₂SO₄: 100 g/L
- Temperature: 35°C, Current density: 20 A/dm², Plating time: 30 sec

Thereafter, the surface of the ultra-thin copper foil was further subjected to thermal and chemical resistance treatment, chromate treatment, and silane coupling treatment.

### <Example 2>

A carrier foil-attached copper foil was manufactured by the same method as in Example 1 except that a buffer layer was formed with a thickness of 25 nm. The buffer layer plating conditions were as follows.
- Copper concentration: 5-10 g/L, Ni concentration: 50-100 g/L, Boric acid concentration: 20-50 g/L
- Temperature: 30°C, Current density: 2.0 A/dm², Plating time: 1.8 sec

### <Example 3>

A carrier foil-attached copper foil was manufactured by the same method as in Example 1 except that a buffer layer was formed with a thickness of 45 nm. The buffer layer plating conditions were as follows.
- Copper concentration: 5-10 g/L, Nickel concentration: 50-100 g/L, Boric acid concentration: 20-50 g/L
- Temperature: 30°C, Current density: 2.0 A/dm², Plating time: 3.3 sec

### <Example 4>

A carrier foil-attached copper foil was manufactured by the same method as in Example 1 except that an inorganic release layer was formed as a release layer. The inorganic release layer was formed as the release layer by Mo-Ni-Fe plating. The deposition amount in the formed release layer was 0.9 mg/dm², and the composition of the release layer was 60.31 wt% of Mo, 31.6 wt% of Ni, and 8.09 wt% of Fe.
- Mo concentration: 10-30 g/L, Ni concentration: 3-10 g/L, Fe concentration: 1-5 g/L, sodium citrate: 100-200 g/L
- pH: 10.2 (30 ml/L ammonia water being added), Temperature: 30°C, Current density: 8 A/dm², Plating time: 6 sec

### <Comparative Example 1>

A carrier foil-attached copper foil was manufactured by the same method as in Example 1 except that a buffer layer was omitted.

### <Comparative Example 2>

A carrier foil-attached copper foil was manufactured by the following method.

### A. Carrier foil

An electrolytic copper foil with a surface roughness of 1.2 µm and a thickness of 18 µm was used as a carrier foil.

### B. Diffusion barrier layer

A diffusion barrier layer was formed on the carrier foil by Ni plating. The plating bath and plating conditions were as follows. The amount of metal (Ni) deposition in the formed diffusion barrier layer was 352 µg/dm².
- Ni concentration: 15-25 g/L, P concentration: 10-20 g/L, pH: 4.0
- Temperature: 30°C, Current density: 1.5 A/dm², Plating time: 2 sec

### C. Release layer

A release layer was formed by Mo-Ni-Fe plating. The deposition amount in the formed release layer was 0.9 mg/dm², and the composition of the release layer was 60.31 wt% of Mo, 31.6 wt% of Ni, and 8.09 wt% of Fe.
- Mo concentration: 10-30 g/L, Ni concentration: 3-10 g/L, Fe concentration: 1-5 g/L, sodium citrate: 100-200 g/L,
- pH: 10.2 (30 ml/L ammonia water being added), Temperature: 30°C, Current density: 8 A/dm², Plating time: 6 sec

### D. Heat-resistant layer

A heat-resistant layer was formed under the following plating bath and plating conditions. The amount of Ni deposition in the formed heat-resistant layer was 33 µg/dm².
- Ni concentration: 15-25 g/L, P concentration: 10-20 g/L
- pH: 4.0, Temperature: 30°C, Current density: 0.5 A/dm², Plating time: 2 sec

### E. Ultra-thin copper foil

An ultra-thin copper foil was formed under the following plating bath and plating conditions. The plating thickness was 2 µm.
- CuSO₄-5H₂O: 250 g/L, H₂SO₄: 100 g/L
- Temperature: 35°C, Current density: 20 A/dm², Plating time: 30 sec

Thereafter, the surface of the ultra-thin copper foil was further subjected to thermal and chemical resistance treatment, chromate treatment, and silane coupling treatment.

### <Comparative Example 3>

A carrier foil-attached copper foil was manufactured by the same method as in Example 1 except that the thickness of a buffer layer (anti-blistering layer) was 15 nm.

The buffer layer plating conditions were as follows.
- Copper concentration: 5-10 g/L, Ni concentration: 50-100 g/L, Boric acid concentration: 20-50 g/L
- Temperature: 30°C, Current density: 2.0 A/dm², Plating time: 1.5 sec

### <Comparative Example 4>

A carrier foil-attached copper foil was manufactured by the same method as in Example 1 except that the thickness of a buffer layer (anti-blistering layer) was 70 nm.
- Copper concentration: 5-10 g/L, Ni concentration: 50-100 g/L, Boric acid concentration: 20-50 g/L
- Temperature: 30°C, Current density: 2.0 A/dm², Plating time: 1.5 sec

### <Evaluation of properties>

The properties of carrier foil-attached copper foil specimens manufactured in examples and comparative examples were evaluated. Evaluation methods were as follows.

### A. Blistering evaluation

After press processing at each temperature (220°C, 350°C, 400°C) and then the releasing of a carrier foil, a released surface was observed with the naked eye. If even one crater-type blistering site was found, a corresponding specimen was determined to be poor.

### B. AES analysis

Analysis was conducted using PHI 700TM (Scanning Auger Nanoprobe) as an analyzer. Analysis conditions were as follows.
- Beam size (10 KeV 10 nA): 20 nm
- Analysis area (µm or point): 10 µm x 10 µm, area
- Tilt (°) / Stage Normal (°): 30°/60°
- Analyzer: CMA (cylindrical mirror analyzer)

### C. Optical microscopy analysis

Observation was made with HIROX's HK7700 at a magnification of 200 times.

### D. Peel strength evaluation

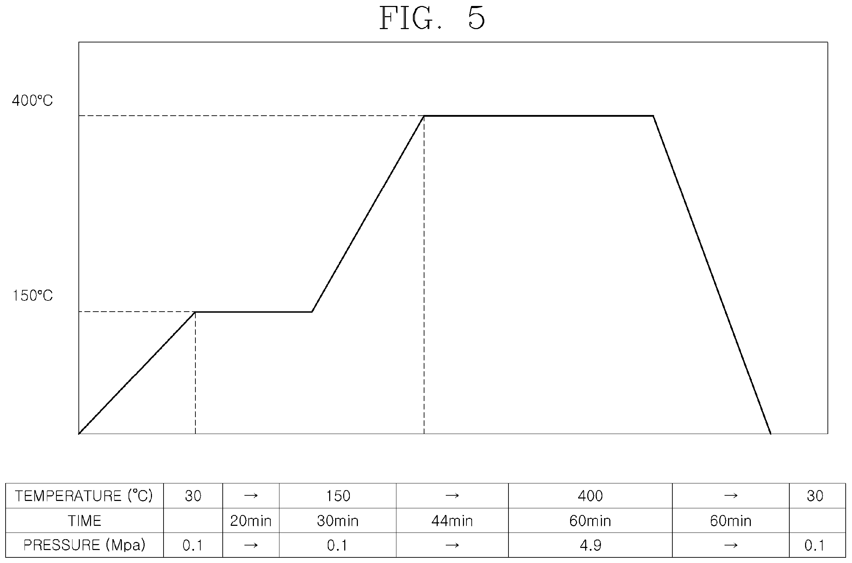

A Teflon resin (thickness: 50µm) was prepared from Mirae EMC, and a copper foil specimen with a width of 30 mm was prepared and then pressed on the resin at temperatures of 220°C, 350°C, and 400°C to prepare samples (press conditions: a pressure of 4.9 Mpa, maintained for 60 minutes). The press condition profile is shown in FIG. 5.

The prepared samples were measured for peel strength by the 90° peeling method according to JIS C 6471 8.1.

Table 1 shows the results of blistering and peel strength.

**TABLE 1**

| Classification | Buffer layer thickness | 220°C Press (crater occurrence or non-occurrence/ peel strength) | 350°C Press (crater occurrence or non-occurrence/ peel strength) | 400°C Press (crater occurrence or non-occurrence/ peel strength) |
|---|---|---|---|---|
| Example 1 | 35 nm | Good/ 15 gf/cm | Good/ 16 gf/cm | Good/ 21 gf/cm |
| Example 2 | 25 nm | Good/ 14 gf/cm | Good/ 18 gf/cm | Good/ 26 gf/cm |
| Example 3 | 45 nm | Good/ 12 gf/cm | Good/ 15 gf/cm | Good/ 19 gf/cm |
| Example 4 | 35 nm | Good/ 14 gf/cm | Good/ 14 gf/cm | Good/ 28 gf/cm |
| Comparative Example 1 | X | Good/ 21 gf/cm | Occurred/ 87 gf/cm | Occurred/ Not released |
| Comparative Example 2 | X | Good/ 18 gf/cm | Occurred/ 79 gf/cm | Occurred/ Not released |
| Comparative Example 3 | 15 nm | Good/ 17 gf/cm | Occurred/ 28 gf/cm | Occurred/ 84 gf/cm |
| Comparative Example 4 | 70 nm | Good/ 4 gf/cm | Good/ 6 gf/cm | Good/ 7 gf/cm |

With respect to Example 1, no blistering occurred by even press at 350°C and 400°C, and the peel strength between the carrier foil and the ultra-thin copper foil was 15 gf/cm for 220°C press, 16 gf/cm for 350°C press, and 21 gf/cm for 400°C press, indicating very good condition. With respect to Example 2, no blistering occurred after press at 350°C and 400°C, and the peel strength between the carrier foil and the ultra-thin copper foil was 14 gf/cm for 220°C press, 18 gf/cm for 350°C press, and 26 gf/cm for 400°C press, indicating very good condition.

With respect to Example 3, no blistering occurred after press at 350°C and 400°C, and the peel strength between the carrier foil and the ultra-thin copper foil was 12 gf/cm for 220°C press, 15 gf/cm for 350°C press, and 18 gf/cm for 400°C press, indicating very good condition.

With respect to Example 4, no blistering occurred after press at 350°C and 400°C, and the peel strength between the carrier foil and the ultra-thin copper foil was 14 gf/cm for 220°C press, 14 gf/cm for 350°C press, and 28 gf/cm for 400°C press, indicating very good condition.

With respect to Comparative Example 1, no blistering occurred after press at 220°C, and the peel strength between the carrier foil and the ultra-thin copper foil was 21 gf/cm for 220°C press, indicating good condition. However, for 350°C press, blistering occurred and the peel strength was 87 gf/cm, indicating that the carrier foil and the ultra-thin foil were difficult to separate. For 400°C press, blistering occurred, and the release of the carrier foil from the ultra-thin foil was impossible.

With respect to Comparative Example 2, no blistering occurred after press at 220°C, and the peel strength between the carrier foil and the ultra-thin copper foil was 18 gf/cm for 220°C press, indicating good condition. However, for 350°C press, blistering occurred and the peel strength was 79 gf/cm, indicating that the carrier foil and the ultra-thin foil were difficult to separate. For 400°C press, blistering occurred, and the release of the carrier foil from the ultra-thin foil was impossible.

With respect to Comparative Example 3, no blistering occurred after press at 220°C, and the peel strength between the carrier foil and the ultra-thin copper foil was 17 gf/cm for 220°C press, indicating good condition. However, for 350°C press, blistering occurred and the peel strength was 28 gf/cm, indicating good condition. In addition, for 400°C press, blistering occurred and the peel strength was 84 gf/cm, indicating that the carrier foil and the ultra-thin foil were difficult to separate.

With respect to Comparative Example 4, no blistering occurred after press at 220°C, 350°C, and 400°C, and the peel strength between the carrier foil and the ultra-thin copper foil was 4 gf/cm for 220°C press, 6 gf/cm for 350°C press, and 7 gf/cm for 400°C press, indicating that the peel strength was significantly low.

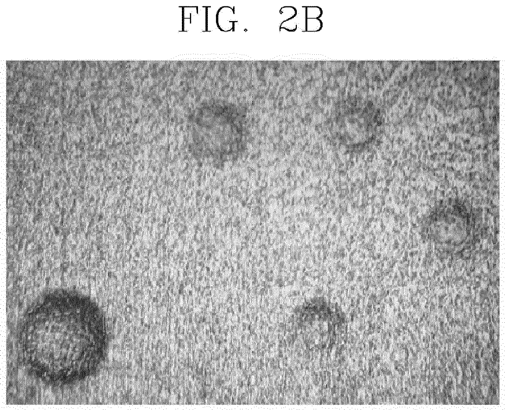

FIGS. 2A and 2B are optical microscope images taken from released surfaces of ultra-thin copper foils after samples of Example 1 and Comparative Example 1 were subjected to press processing at 350°C and then releasing of carrier foils, respectively.

Referring to the drawings, the released surface was clean in Example 1, whereas the released surface had hollow craters in Comparative Example 1. These were due to blistering near the release layer during press.

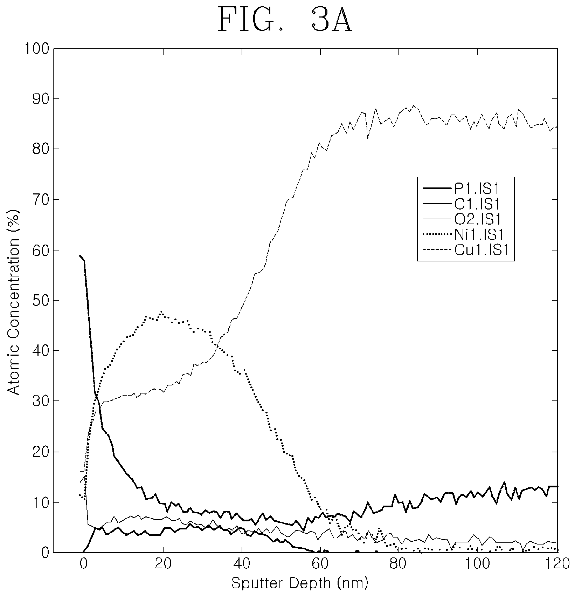

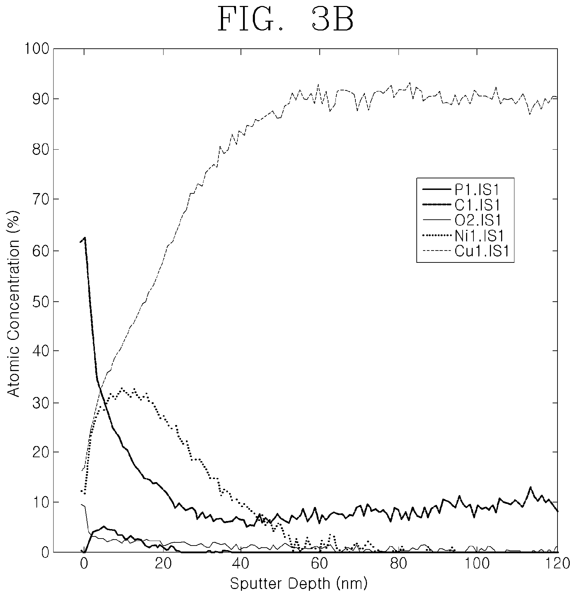

FIGS. 3A and 3B are AES analysis graphs of carrier foil-attached copper foil samples manufactured in an example and a comparative example, respectively.

Referring to the drawings, Example 1, compared with Comparative Example 1, showed peaks indicating Cu peaks and Ni peaks, which seemed to be caused by containing of Cu and Ni in the buffer layer.

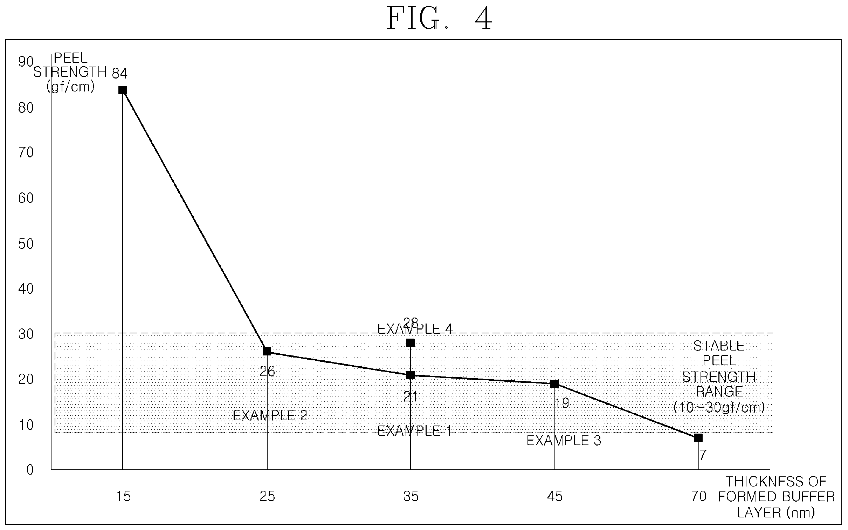

FIG. 4 is a graph plotting the peel strength measurement results after samples of an example and a comparative example were subjected to pressing at 400°C.

Referring to FIG. 4, it can be seen that Examples 1 to 4 were within a stable peel strength range of 10-30 kg/cm.

The specified matters and limited exemplary embodiments and drawings such as specific elements in the present disclosure have been disclosed for broader understanding of the present disclosure, but the present disclosure is not limited to the exemplary embodiments, and various modifications and changes are possible by those skilled in the art without departing from an essential characteristic of the present disclosure. Therefore, the spirit of the present disclosure is defined by the appended claims rather than by the description preceding them, and all changes and modifications that fall within metes and bounds of the claims, or equivalents of such metes and bounds are therefore intended to be embraced by the range of the spirit of the present disclosure.

### [Industrial Applicability]

The present disclosure can be applied to a copper foil, a carrier foil-attached copper foil, and a copper-clad laminate.

## Claims

1. A carrier foil-attached copper foil comprising: a carrier foil; a release layer on the carrier foil; a heat-resistant layer on the release layer; and an ultra-thin copper foil on the heat-resistant layer, wherein a buffer layer of a Ni alloy is interposed between the release layer and the heat-resistant layer.

2. The carrier foil-attached copper foil of claim 1, wherein the buffer layer contains a Cu-Ni alloy.

3. The carrier foil-attached copper foil of claim 2, wherein the buffer layer is obtained by plating with a plating solution with a concentration ratio of Cu and Ni being 1:5 to 1:20.

4. The carrier foil-attached copper foil of claim 1, wherein the buffer layer has a thickness of 20-50 nm.

5. The carrier foil-attached copper foil of claim 1, wherein the heat-resistant layer has a thickness of 5-50 nm.

6. The carrier foil-attached copper foil of claim 1, wherein the release layer is an organic release layer.

7. The carrier foil-attached copper foil of claim 1, wherein the release layer is an inorganic release layer.

8. The carrier foil-attached copper foil of claim 1, wherein the heat-resistant layer is a Ni plating layer.

9. The carrier foil-attached copper foil of claim 8, wherein the heat-resistant layer is obtained by plating with a plating solution containing Ni and P.

10. The carrier foil-attached copper foil of claim 8, wherein the 90-degree peel strength after press processing at 400°C for 60 min is 10-30 gf/cm.

11. A copper-clad laminate comprising a copper foil laminated on a resin substrate, wherein the copper foil is prepared by joining the carrier foil-attached copper foil of claim 1 to the resin substrate.

12. The copper-clad laminate of claim 11, wherein the resin substrate is at least one selected from the group consisting of a polyimide, a fluorine resin, and an LCP resin.
